Europäisches Patentamt

European Patent Office

Office européen des brevets

(11) Publication number: **0 334 393**
**A2**

# EUROPEAN PATENT APPLICATION

(21) Application number: **89109083.9**

(22) Date of filing: **27.04.84**

(51) Int. Cl.⁴: **H01H 51/22**

(30) Priority: **28.04.83 JP 64888/83 U**
**12.08.83 JP 126061/83 U**
**05.10.83 JP 187232/83**
**08.10.83 JP 188925/83**

(43) Date of publication of application:
**27.09.89 Bulletin 89/39**

(60) Publication number of the earlier application in
accordance with Art.76 EPC: **0 124 109**

(84) Designated Contracting States:
**AT BE CH DE FR GB IT LI LU NL SE**

(71) Applicant: **OMRON TATEISHI ELECTRONICS
CO.**
**10, Tsuchido-cho Hanazono Ukyo-ku
Kyoto(JP)**

(72) Inventor: **Bando, Yoshihide**
**78, Sakurazono-cho Kawashima
Nishikyo-ku Kyoto(JP)**
Inventor: **Maenishi, Kozo**
**5-29, Yakushido Imazoto
Nagaokakyo-shi Kyoto(JP)**
Inventor: **Nakanishi, Yoichi**
**95-1, Matsumoto-cho Kami-gamo
Kita-ku Kyoto(JP)**

(74) Representative: **WILHELMS, KILIAN &
PARTNER Patentanwälte
Eduard-Schmid-Strasse 2
D-8000 München 90(DE)**

(54) **Electromagnetic relay with symmetric reaction.**

(57) An electromagnetic relay includes a coil wound around a core both of whose ends project therefrom. A yoke extends parallel thereto, and each of its ends is formed with two pole pieces which extend towards and lie one of each side of an end of the core with a certain gap being defined therebetween. A connecting member extends parallel to the core and the yoke and is mounted so as to be movable transversely, and means are provided for establishing and breaking some electrical connection according to such transverse movement. There are provided two armature pieces, one for each end of the core and both fixed to the connecting member. Each armature piece includes a permanent magnet plate and two plates of magnetic material fixed to it so as generally to form a C shape with one of the magnetic material plates being magnetized to be a north pole and the other a south pole. Each of the two plates of magnetic material is inserted on one side of an end of the core between it and the opposing one of the pole pieces of the yoke, into the gap therebetween. The directions of magnetization of the armature pieces are oppositely oriented. Thereby, when the relay switches over, it does so without generating any off center jerking, and thus its mounting to a base is improved. Also the quality of the magnetic circuit, and the manufacturability of the relay, are improved.

F I G. 3

## ELECTROMAGNETIC RELAY WITH SYMMETRIC REACTION

### BACKGROUND OF THE INVENTION

The present invention relates to an electromagnetic relay, and more particularly relates to an electromagnetic relay in which switch contacts are switched over by movement of an armature assembly in response to the energization of an electromagnet, in which no asymmetric reaction force is produced when the device is switched.

There is a known type of electromagnetic relay, which will now be described. An electromagnetic coil is wound on a spool, and the spool is fixedly mounted to a yoke member which has a first end portion at one end of the spool and two end portions at the other end of the spool somewhat spaced apart from one another which consistute magnetic pole pieces. An iron core is inserted through the middle of the spool and is held in place by its one end being crimped to said first end portion of the yoke member; in this position, the other end of said iron core, which constitutes another magnetic pole piece, is held between the pole pieces constituted by said two other end portions of the yoke member, each of which lies to one side of said end of said iron core with a certain gap being defined therebetween. Thus, when the electromagnet is energized, a magnetic circuit is created, and the two pole pieces of the yoke are magnetized to become poles of a particular polarity, for example in the case of energization in a particular direction they become south poles, while the end of the iron core between them is magnetized to become a pole of the opposite polarity, i.e. in this example becomes a north pole. An armature piece is made up by two iron plates being joined together by a plate shaped permanent magnet in approximately a C-shaped configuration, with one of the iron plates being thus magnetized to be a north pole and the other a south pole. This armature piece is positioned with the two iron plates inserted into the aforementioned gaps between the poles defined by said other end portions of the yoke member and the pole defined by said end of said iron core, and is mounted on on a block member which can move from side to side so that the iron plates can move towards and away from said end of said iron core. Contacts are provided which are opened and closed according to said sideways motion of said block member, either directly or via spring pieces which are bent thereby. Depending on the configuration, sideways biasing may be supplied to the block member.

Thus, when the coil is energized in said particular direction, the one of the pole pieces which is magnetized to be a north pole by the permanent magnet is attracted to the pole piece of the yoke on its one side and is repelled from the side of the end of the iron core on its other side, while on the other hand the other one of the pole pieces which is magnetized to be a south pole by the permanent magnet is repelled from the pole piece of the yoke on its one side and is attracted to the side of the end of the iron core on its other side; and thereby the block member is biased in a certain sideways direction, and moves so as to open or close certain of its contacts. On the other hand, when the coil is energized in the electrical direction opposite to said particular direction, the one of the pole pieces which is magnetized to be a north pole by the permanent magnet is repelled from the pole piece of the yoke on its one side and is attracted to the side of the end of the iron core on its other side, while on the other hand the other one of the pole pieces which is magnetized to be a south pole by the permanent magnet is attracted to the pole piece of the yoke on its one side and is repelled from the side of the end of the iron core on its other side; and thereby the block member is biased in the opposite sideways direction, and moves so as to close or open said certain of its contacts. (The position when the coil is not energized can be either of these positions or a position intermediate between them, depending on the biasing of the block member). Thereby the contacts are reliably and positively switched, and a good and efficient magnetic circuit with little loss of magnetic flux is provided.

However, this device has a shortcoming, in that the movement of the block member occurs to and fro along a line which is offset from the general center of the device including its center of gravity, which generally passes through or near the center of the electromagnetic coil. Therefore, when the relay performs switching action, an unbalanced and off center jerking force is caused to be applied to the base board such as a printed circuit board to which the relay is fitted, and this off center jerking force creates a jerking torque around the center of gravity the relay. This can give rise to various problems with regard to the fixing of the relay to the printed circuit board, and can mean that after a certain service life the fixing of the relay becomes loosened.

Another disadvantage of the construction outlined above is that, because the one end of the iron core is crimped to said first end portion of the yoke member, the integrity of the magnetic circuit is not perfectly assured. Such crimping, if imperfectly done, can greatly raise the magnetic resistance of the magnetic circuit, thus deteriorating relay performance. Yet in the outlined prior art construction the use of such crimping for fixing the end of the iron core to the yoke member is very much preferable from the point of view of convenience and cost of assembly.

An expedient that might be thought of for curing the above outlined unbalance problem might be to provide two of the relay construction detailed above mounted back to back, so that the two forces due to the movements of their armature assemblies were on opposite sides of their center of gravity and the unbalanced portions thereof canceled one another out; but this would increase the overall size and particularly the length of the device, and would increase its cost substantially. Further, this expedient would not solve the problem that the crimping can deteriorate the quality of the magnetic circuit.

Another problem that arises in particular with an electromagnetic relay for switching high frequency current is that of leakage of high frequency current between the various terminals thereof. It has been practiced to shield the body of the relay, and the mechanisms inside it, as much as practicable, but still the problem is not completely solved. Further, often shielding of the relay terminals is performed by providing a plated surface on the outside body of the relay from which the terminals protrude. When the relay is mounted to, for example, a printed circuit board, and is pressed thereagainst so as to engage the terminals well thereto, then this plated surface is brought into contact with a ground surface on the printed circuit board, and is thereby grounded. However, problems have arisen because, since this plated surface is pressed close against the printed circuit board, it is very difficult to eliminate all residue of flux between them. Such residual flux can cause corrosion, both of the terminals and of the plated surface itself, and this can result in poor electrical contact between the plated surface and the ground surface of the board, which can in turn cause unacceptable high leakage of high frequency current.

Another problem that has arisen with such a plated surface on the relay is that it can occur that poor contact happens between the plated surface and the ground terminals which are providing grounding therefor. This is primarily because the joining area or cross section between such a thin film and a ground terminal protruding from the base is extremely limited in its extent.

Yet another important characteristic for such a relay is good sealability, which has in the prior art proved difficult to obtain as a result of inevitable inaccuracies of manufacture.

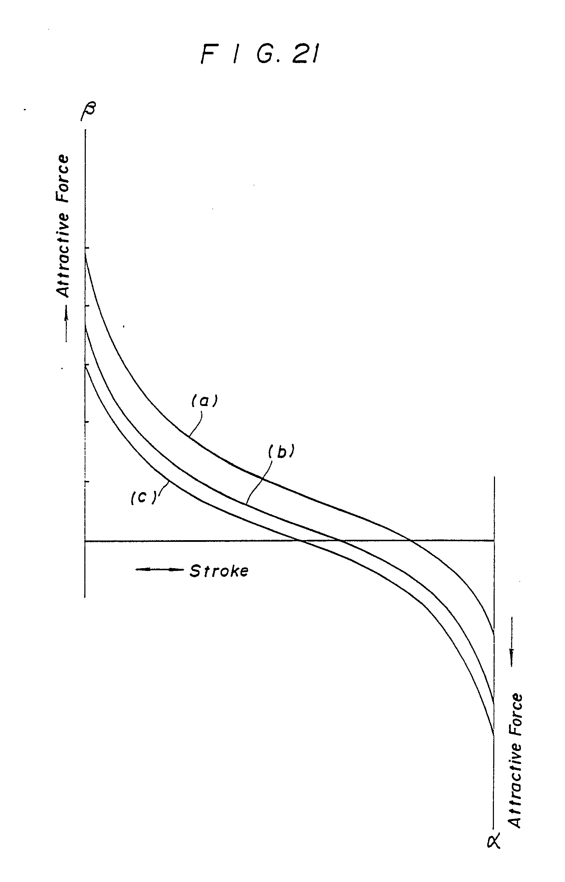

A final important question that arises in the design and production of an electromagnetic relay is the importance of adjusting the load characteristics of an armature assembly thereof. As schematically illustrated in Fig. 21 of the accompanying drawings, which shows the force on the armature assembly along the vertical axis and the displacement of said armature assembly along the horizontal axis, it is desirable that the load curve of the armature assembly should fall between the actuation property curve (based on the voltage applied to the coil of the relay) and the restoring property curve. However, in the past the adjustment of the load curve of an electromagnetic relay of this type has been performed by adjusting a single sheet spring which is used for restoring the armature, and this makes it difficult to rigorously adapt the movement characteristics of the armature to more rigorous requirements. Furthermore, due to fluctuations in the mechanical characteristics of the parts inevitably caused by manufacturing tolerances, and due to assembly inaccuracies, the load curve may depart from the desired one to some extent. And if only one sheet spring is used for restoring the position of the armature assembly then it is very difficult to properly fine adjust the load characteristics of the relay.

## SUMMARY OF THE INVENTION

Accordingly, it is the primary object of the present invention to provide an electromagnetic relay during the operation of which no off center jerking force are generated.

It is a further object of the present invention to provide such an electromagnetic relay, which does not easily come loose from its mountings after some time in service.

It is a further object of the present invention to provide such an electromagnetic relay, which is reliable in service.

It is a further object of the present invention to provide such an electromagnetic relay, which can be manufactured so as to be consistent in its operational properties.

It is a further object of the present invention to provide such an electromagnetic relay, which can be manufactured easily and cheaply.

It is a further object of the present invention to provide such an electromagnetic relay, which is compact in size.

It is a yet further object of the present invention to provide such an electromagnetic relay, which does not suffer from undue leakage of high frequency current.

It is a yet further object of the present invention to provide such an electromagnetic relay, which provides continued good contact between a shielding surface thereof and a ground surface on a board to which it is mounted.

It is a yet further object of the present invention to provide such an electromagnetic relay, which is not subject to an accumulation of flux tending to remain between it and a printed circuit board to which it is fitted.

It is a further object of the present invention to provide such an electromagnetic relay, whose load characteristics can be conveniently and easily fine adjusted.

It is a further object of the present invention to provide such an electromagnetic relay, in the adjustment of which fluctuations due to manufacturing tolerances and assembly inaccuracies can be compensated for.

According to one aspect of the present invention, these and other objects are accomplished by an electromagnetic relay, comprising: (a) a core made of magnetic material; (b) and electromagnetic coil wound around said core so that the two ends of said core project therefrom and constitute core end poles; (c) a yoke extending generally parallel to said core, each end of said yoke being formed with two pole pieces which extend towards the corresponding end pole of said core so as to lie one on each side thereof with a certain gap being defined therebetween; (d) a connecting member extending generally parallel to said core and said yoke and mounted so as to be movable transversely to its longitudinal axis; (e) means for establishing and breaking electrical connection according to movement of said connecting member transversely to its longitudinal axis; and (f) two armature pieces, one for each end of said core, both fixed to said connecting member, and each comprising a permanent magnet plate and two plates of magnetic material fixed to said permanent magnet plate so as generally to form a C shape with one of said magnetic material plates being magnetized to be a north pole and the other being magnetized to be a south pole, each of the two plates of magnetic material being inserted on one side of said end of said core between the side of said end of said core and the opposing one of said pole pieces of said yoke into said gap therebetween; (g) the directions of magnetization of said armature pieces being oppositely oriented.

According to such a structure, since the directions of magnetization of the armature pieces are opposite, when the electromagnetic coil is energized and one of the two ends of the core becomes a north pole while the other becomes a south pole, the armature pieces are both impelled in the same direction transverse to the longitudinal axis of the coil and the core, so that the connecting member as a whole is impelled transversely thereby to switch the electrical connections. This action is performed in a symmetrical fashion with respect to the center of gravity of the device, and thus does not generate any off center jerking. Thus the mounting of the relay to a base is improved, because no torsional vibrations are generated during repeating switching actions which might lead to its being loosened therefrom. Also, because no crimped construction is used, the quality of the magnetic circuit, and the manufacturability of the relay, are improved. And it is maintained compact in size and particularly short in length.

According to another aspect of the present invention, these and other objects are accomplished by an electromagnetic relay, comprising: a base; a plurality of contact terminals projecting from said base; a plurality of ground terminals on the sides of each of the contact terminals; and a plurality of stop projections on the sides of the contact terminals, extending from said base by substantially smaller distances than do said contact terminals and said ground terminals, and electrically connected to said ground terminals.

According to such a structure, when the relay is mounted, as for example to a printed circuit board, and is pushed thereagainst so as to engage said contact terminals and said ground terminals to contacts thereon, then the stop projections prevent the relay being forced quite against said board so as to contact the surface of said base against the surface of said board. Thus, a gap is forced to remain between said base and said printed circuit board, and this is very effective for preventing the lingering of flux between the relay and the board. Accordingly the corrosion of the terminals or of the relay which might be caused by said flux is prevented. Further, since the stop projections and the ground terminals are provided around the contact terminals, the leakage of high frequency current signals is prevented, and although this relay may be made very compact and at a high design density no problems arise with regard to such signal leakage. Accordingly this relay has superior high frequency characteristics.

Further, these and other objects are accomplished by an electromagnetic relay, comprising: an electromagnetic; an armature assembly opposed to said electromagnet which moves according to the selective energization of said electromagnet; a contact mechanism which operates according to said movement of said armature assembly; and a pair of sheet springs which support said armature assembly so that it can reciprocate along its direction of motion.

According to such a construction, as will be explained in detail later, the operational characteristics of the relay can be easily and conveniently adjusted by varying the characteristics of the two sheet springs.

Further, these and other objects are accomplished by an electromagnetic relay, comprising: a base formed with an insertion socket and provided with an electroconductive coating; a terminal platform having terminals mounted therein and fitted in said insertion socket; and a ground base board fixed against said base so as to pressingly hold said terminal platform in said socket and so as to contact said electroconductive coating.

According to such a construction, since the terminal platform is pressingly held into said insertion socket by the terminal platform, very good sealing characteristic are obtained. Further, since the ground base board contacts said electroconductive coating over a plane surface which typically has a large surface area, the grounding of said electroconductive coating is very good, and accordingly shielding of the relay is good and leakage of high frequency current is effectively prevented.

## BRIEF DESCRIPTION OF THE DRAWINGS

The present invention will now be shown and described with reference to the preferred embodiments thereof, and with reference to the illustrative drawings, which are all of them given purely for the purposes of explanation and exemplification only, and are not of them intended to be limitative of the scope of the present invention in any way. In the drawings, like parts and features are denoted by like reference symbols in Figs. 1 through 5 thereof, Figs. 6 through 17 thereof, Figs. 18 through 22 thereof, and Figs. 23 through 27 thereof, and:

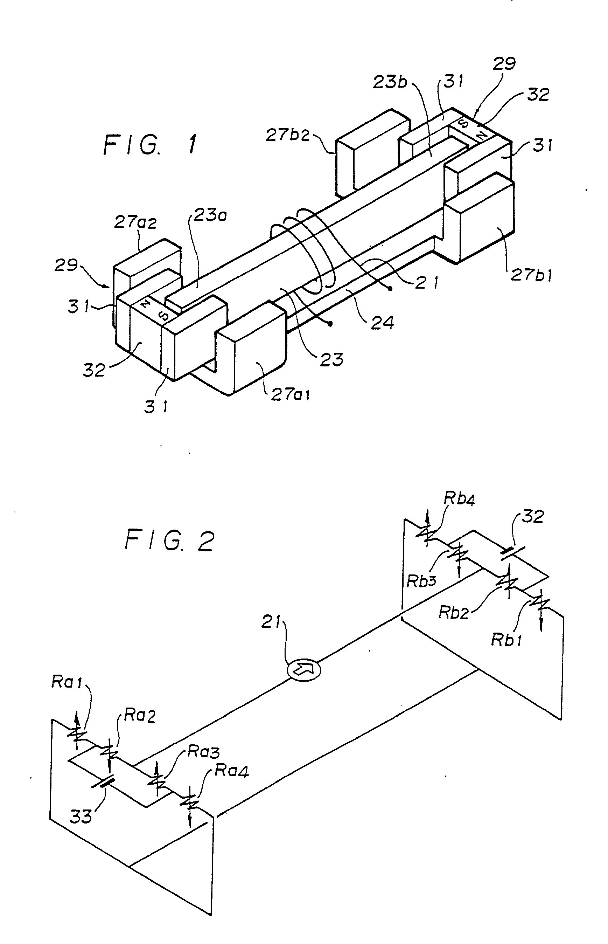

Fig. 1 is a schematic perspective view of the main components of the first preferred embodiment of the electromagnetic relay according to the present invention;

Fig. 2 is a perspective view of the magnetic circuit of said first preferred embodiment;

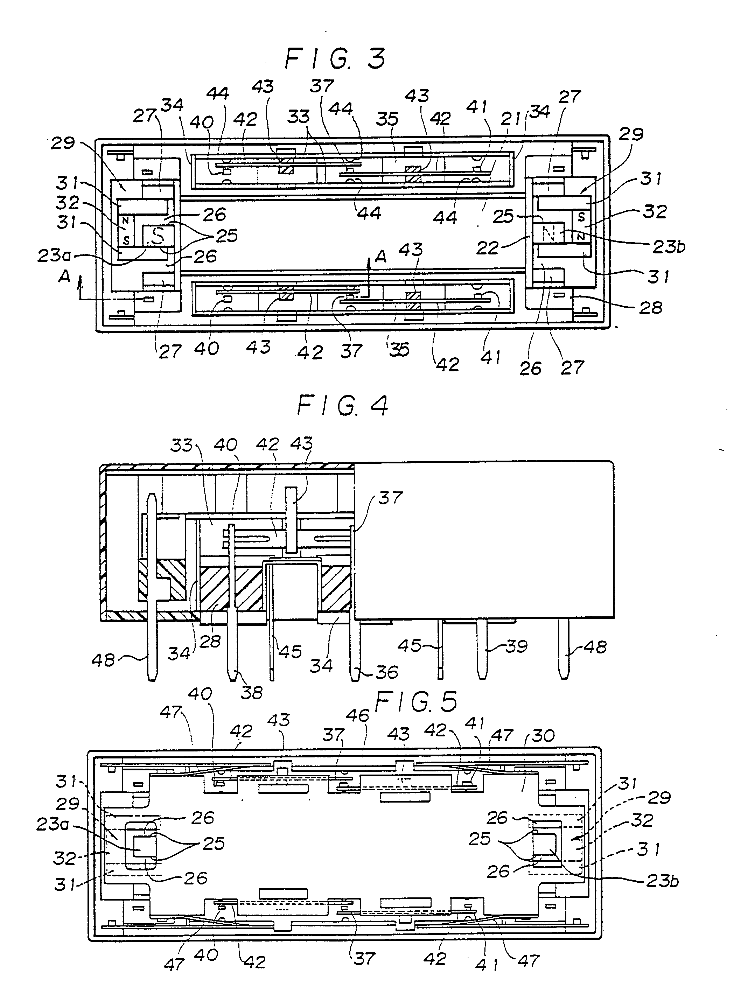

Fig. 3 is a plan view of the inside of said first preferred embodiment, with a connecting member removed;

Fig. 4 is a sectional view taken in a plane shown by the arrows A - A in Fig. 3;

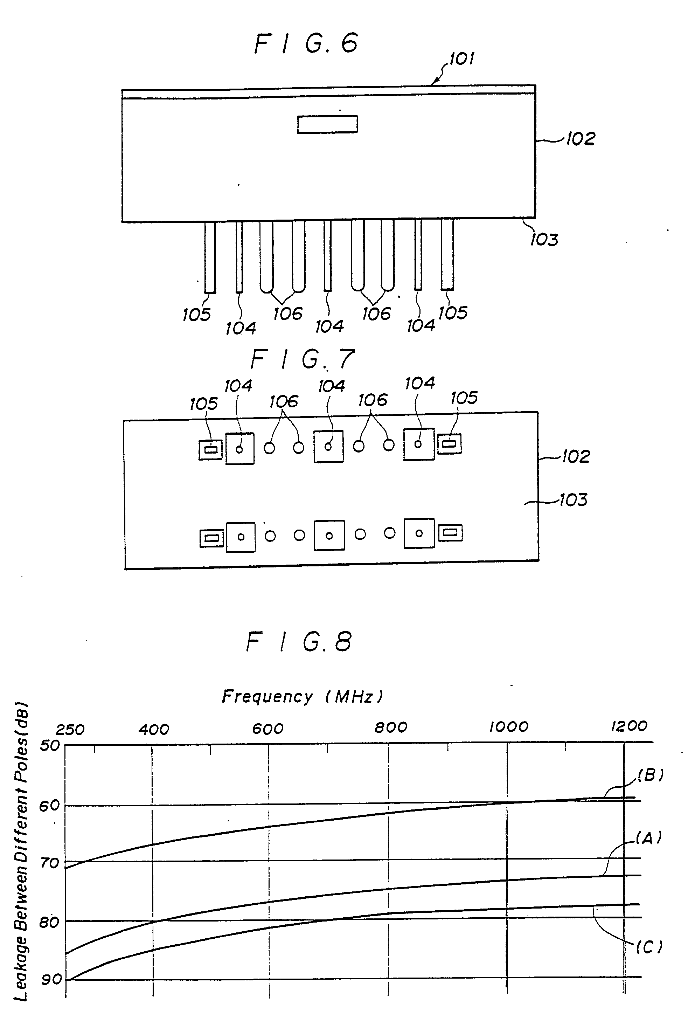

Fig. 5 is a plan view of the inside of said first preferred embodiment with said connecting member in place;

Fig. 6 is a side view of a prior art type of relay;

Fig. 7 is a bottom view of the prior art relay of Fig. 6;

Fig. 8 is a graph, in which signal leakage between different poles is shown in dB and signal frequency is shown in MHz, illustrating the characteristics of leakage both in the prior art relay of Figs. 6 and in the second preferred embodiment of the relay of the present invention;

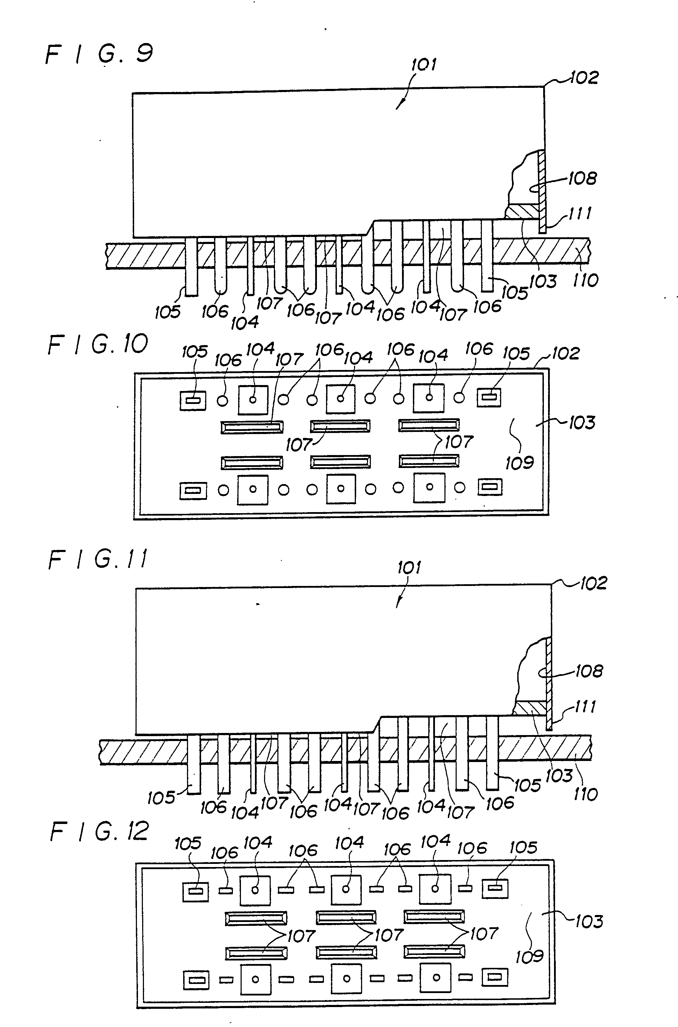

Fig. 9 is a partly broken away side view, similar to Fig. 6, showing the second preferred embodiment of the relay of the present invention, and also showing in section a printed circuit board for mounting it to;

Fig. 10 is a bottom view, similar to Fig. 7, showing said second preferred embodiment of the relay of the present invention;

Fig. 11 is a partly broken away side view, similar to Figs. 6 and 9, showing the third preferred embodiment of the relay of the present invention, and also showing a printed circuit board;

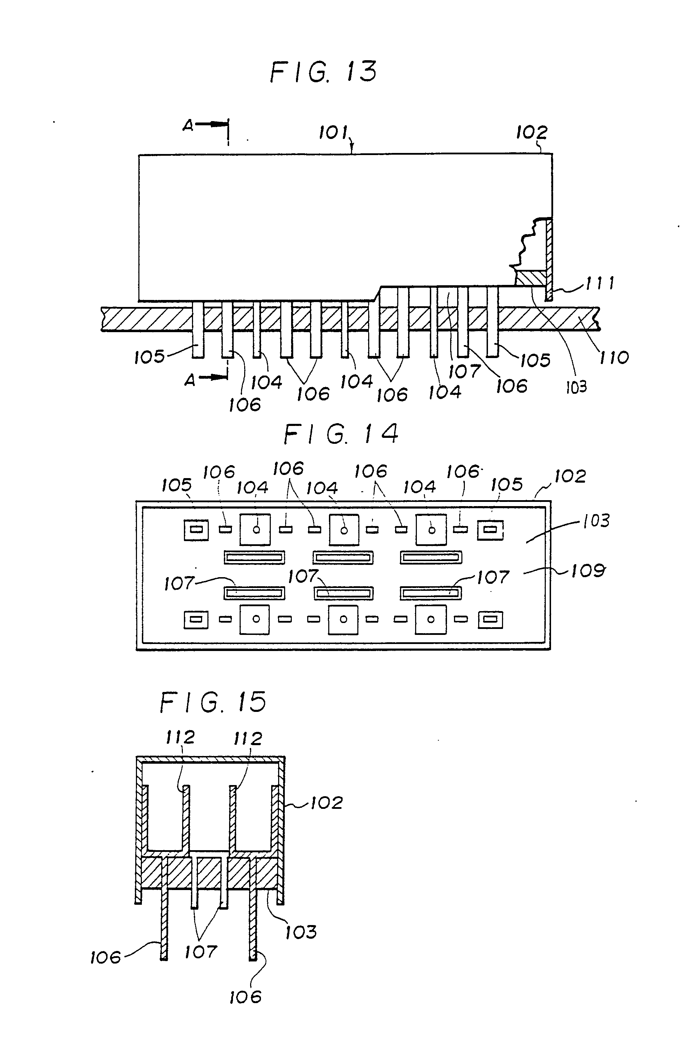

Fig. 12 is a bottom view, similar to Fig. 7 and 10, showing said third preferred embodiment of the relay of the present invention;

Fig. 13 is a partly broken away side view, similar to Figs. 6, 9, and 11, showing the fourth preferred embodiment of the relay of the present invention, and also showing a printed circuit board;

Fig. 14 is a bottom view, similar to Fig. 7, 10, and 12, showing said fourth preferred embodiment of the relay of the present invention;

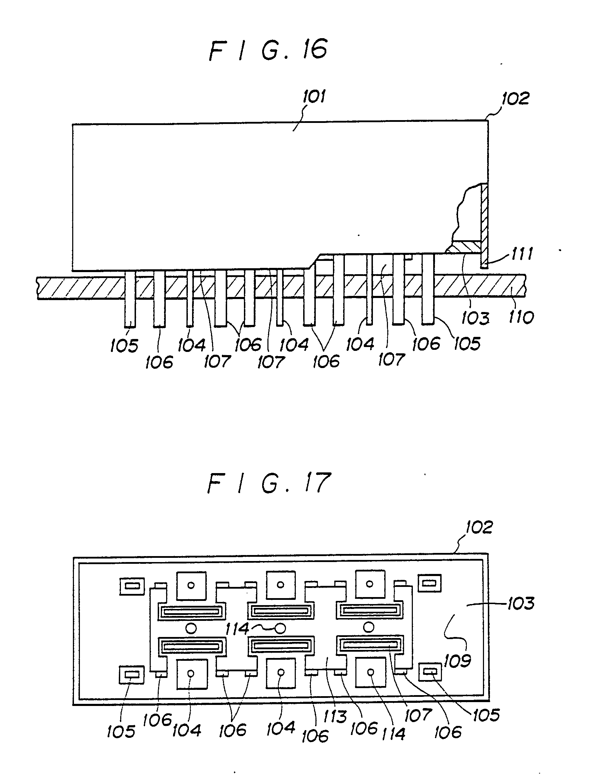

Fig. 15 is a sectional view through said fourth preferred embodiment, taken in a plane shown by the arrows A - A in Fig. 13;

Fig. 16 is a partly broken away side view, similar to Figs. 6, 9, 11, and 13, showing the fifth preferred embodiment of the relay of the present invention, and also showing a printed circuit board;

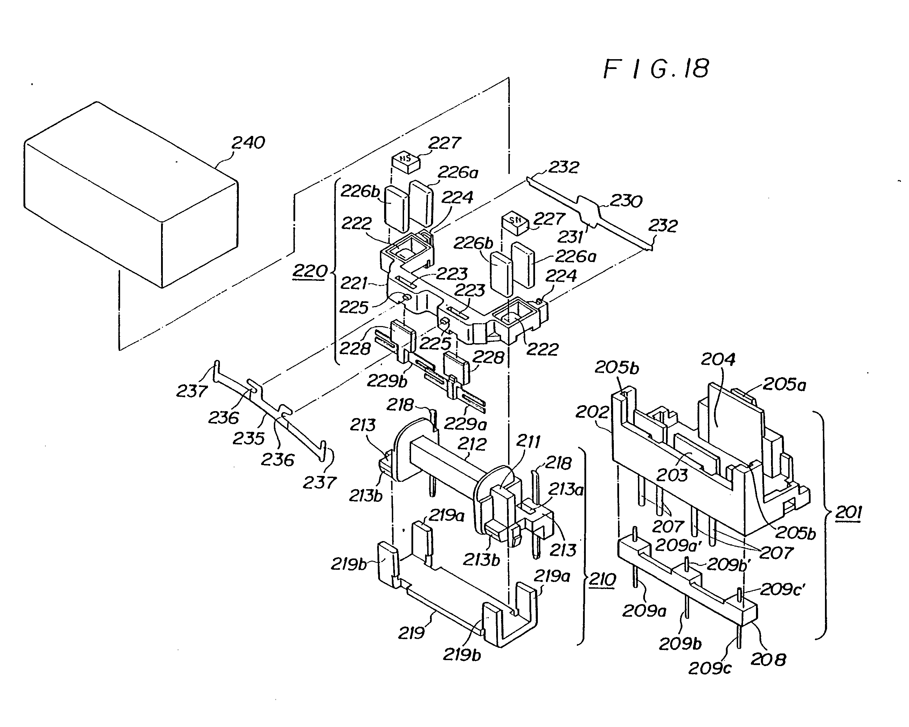

Fig. 17 is a bottom view, similar to Fig. 7, 10, 12, and 14, showing said fifth preferred embodiment of the relay of the present invention;

Fig. 18 is an exploded perspective view showing the detailed construction of a sixth preferred embodiment of the relay of the present invention;

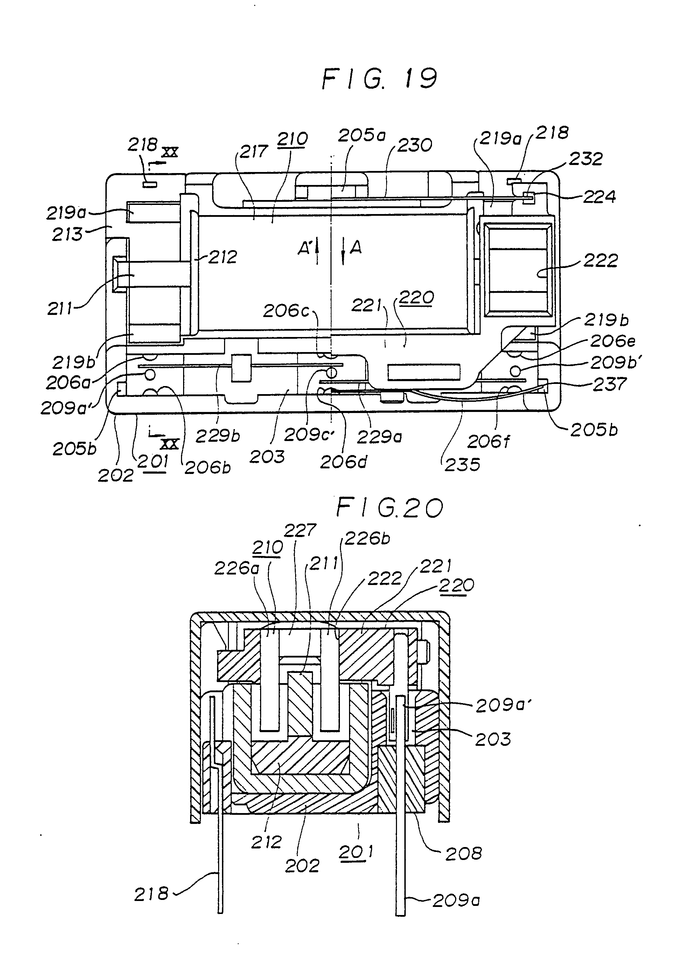

Fig. 19 is a plan view of said sixth preferred embodiment;

Fig. 20 is a sectional view through said sixth preferred embodiment, taken in a plane shown by the arrows XX - XX in Fig. 19;

Fig. 21 is a graph, in which the stroke of a switching element is shown along the horizontal axis and attractive force is shown along the vertical axis, giving the switching characteristics of a desired relay;

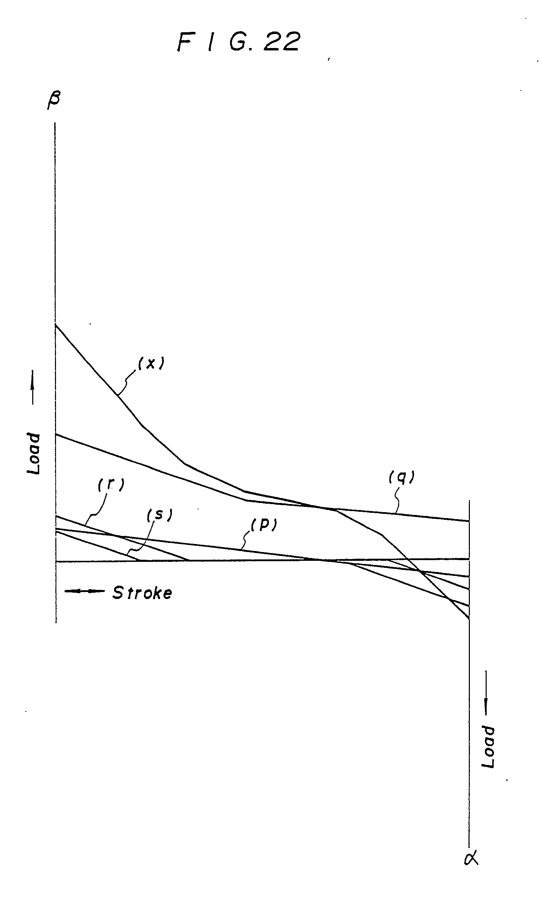

Fig. 22 is a graph, in which also the stroke of a switching element is shown along the horizontal axis and attractive force is shown along the vertical axis, giving the actual switching characteristics of the relay of Figs. 18, 19, and 20;

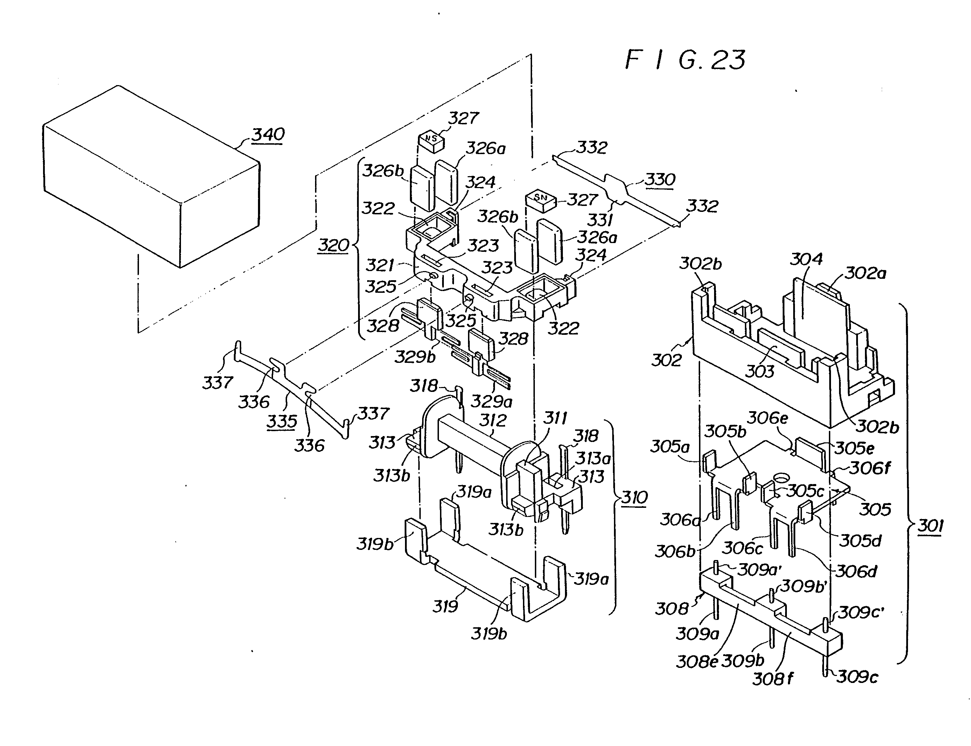

Fig. 23 is an exploded perspective view, similar to Fig. 18, showing the detailed construction of a seventh preferred embodiment of the relay of the present invention;

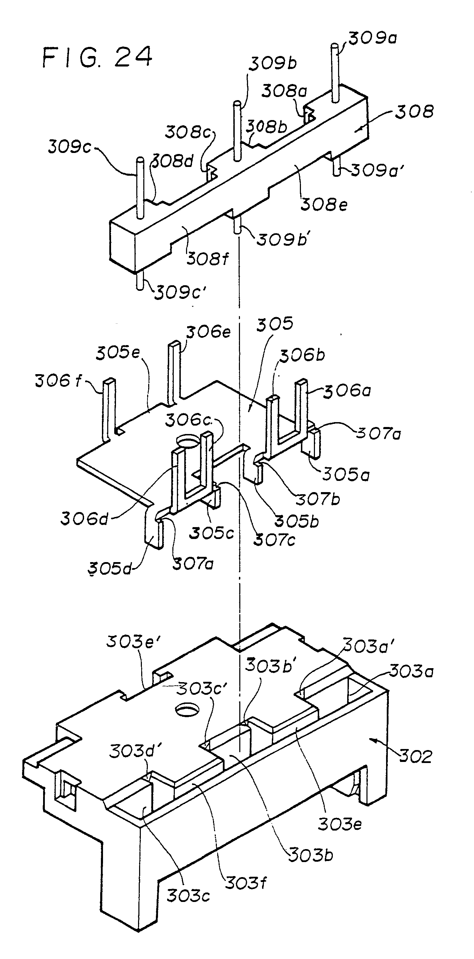

Fig. 24 is an exploded perspective view of a base and a terminal platform of said seventh preferred embodiment;

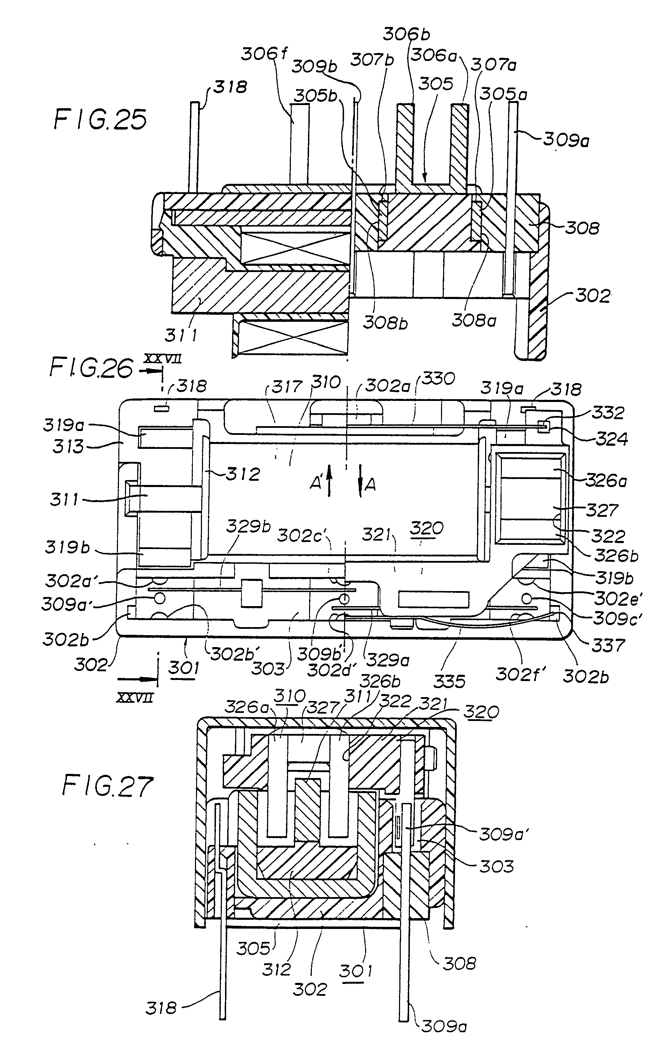

Fig. 25 is a sectional view of said base and said terminal platform;

Fig. 26 is a plan view of said seventh preferred embodiment; and

Fig. 27 is a sectional view through said seventh preferred embodiment, taken in a plane shown by the arrows XXVII - XXVII in Fig. 26.

## DESCRIPTION OF THE PREFERRED EMBODIMENTS

The present invention will now be described with reference to the preferred embodyments thereof, and with reference to the appended drawings. Fig. 1 shows in schematic perspective view the essential elements of the first preferred embodiment of the electromagnetic relay according to the present invention, and in Fig. 3 there is shown a plan view of the actual device (with its cover removed). An iron core 23 is fitted through the middle of a spool 22 on which an electromagnetic coil 21 is wound. The two ends 23a and 23b of this iron core 23 project out from the ends of the spool 22. A yoke member 24 is provided below the spool 22 (which in fact is fixed thereto although this is not shown in the figures) and the two ends of this yoke member 24 turn upwards as shown in Fig. 1, each being formed in two pole pieces 27a1, 27a2 and 27b1, 27b2. The two pole pieces 27a1 and 27a2 are positioned on opposite sides of the end 23a of the iron core 23 with gaps therebetween, and similarly the other two pole pieces 27b1 and 27b2 are on opposite sides of the other end 23b of the iron core 23 with gaps therebetween. The entire integrally fixed assembly ofof the coil 21, the spool 22, the iron core 23, and the yoke member 24 is fixed to a base 28 of the relay, best seen in Fig. 4 which is a sectional view of Fig. 3 along a plane shown by the arrows A - A in Fig. 3.

Two armatures pieces 29 are each made up by two plate iron members 31 being fixed on opposite ends which define opposite poles of a plate shaped permanent magnet 32, in a generally C-shaped configuration, so that one of the plate members 31 is magnetized to be a north pole and the other is magnetized to be a south pole. Each of these two armature pieces 29 is fixed to one of the ends of a connecting member 30 (see Fig. 5) and projects downwards therefrom, with each of the plate iron members 31 being inserted into one of the gaps between one side of one end of the iron core 23 and one of the pole pieces 27 of the yoke 24, as best shown in Fig. 1. As will be explained shortly, the connecting member 30 can move in the direction transverse to the longitudinal axis of the coil 21 and the iron core 23. Further, particularly according to the concept of the present invention, the armature pieces 29 are fixed to the connecting member 30 with the poles of their permanent magnets 32 oriented in opposite directions. Fig. 2 shows an equivalent magnetic circuit for this construction: in this figure, the magnetic resistances of the gaps between the ends of the iron core 23 and the pole pieces 27 of the yoke member 24 and the iron members 31 are denoted by Ra1 through Ra4 and Rb1 through Rb4.

The electromagnetic relay construction shown can be applied to a single stable type relay or to a latching type relay. In either case, sheet springs 47 (two on each side) are interposed betwen the sides of the connecting member 30 and rising portions 46 of the sides of the base 28 of the relay, with the one ends of the springs 47 fixed to said sides of said connecting member 30 by rivets or the like.

Contacts are provided for being opened and closed by the movement of the connecting member 30, as follows. Contact chambers 35 are provided on both the sides of the spool 22, being defined and protected by side walls 33 and end walls 34 attached to the base 28, and along the central line of each of these chambers 235 there are provided, in order, an A contact 40 near its one end, a common contact 37 near its center, and a B contact 41 near its other end. These contacts are each rods protruding vertically from the floor of the chamber 35, and they extend out from the bottom of the electromagnetic relay as connection terminals: the A contact 40 extends as an A terminal 38, the common contact 37 extends as a common terminal 36, and the B contact 41 extends as a B terminal 39. On each of the side walls 33 of the chambers 35 there are provided, opposing the contacts 40, 37, and 41, ground contacts 44 (six in each chamber 35, therefore). These ground contacts 44 are all connected to a ground terminal 45 which also extends out from the bottom of the electromagnetic relay as a connection terminal. And terminals 48 are provided for providing supply of actuating electrical energy to the coil 21.

Two contact pieces 42 are fixed along each side of the underside of the connecting member 30, by fixing members 43; these contact pieces 42 lie in the chambers 35, and are somewhat springy. For the upper side in Fig. 5 of the connecting member 30, one of the contact pieces 42 extends along from the A contact 40 to the common contact 37, lying to the outside of said contacts, and the other of said contact pieces 42 extends along from the common contact 37 to the B contact 41, lying to the inside of the said contacts; and for the lower side in Fig. 5 of the connecting member 30, one of the contact pieces 42 extends along from the A contact 40 to the common contact 37, lying to the inside of said contacts, and the other of said contact pieces 42 extends along from the common contact 37 to the B contact 41, lying to the outside of said contacts. Thus, when the connecting member 30 is shifted in the upwards direction in Fig. 5, each of the B terminals 39 of the electromagnetic relay is electrically connected to its corresponding common terminal 36 via the B contact 41, the contact piece 42, and the common contact 37, and the A terminals 38 are disconnected from the common terminals 36; whereas when the connecting member 30 is shifted in the downwards direction in Fig. 5, each of the A terminals 38 of the electromagnetic relay is electrically connected to its corresponding common terminal 36 via the A contact 40, the contact piece 42, and the common contact 37, and the B terminals 39 are disconnected from the common terminals 38.

If the relay is in fact to be a single stable type relay, then the sheet springs 47 on one side of the member 30, for example the upper side in Fig. 5, are made weaker than those on the other side, exemplarily the lower side, so that the member 30 is biased to one side, exemplarily the upper side in Fig. 5, and thus in the non energized state of the electromagnetic coil 21 each of the B terminals 39 of the electromagnetic relay is electrically connected to its corresponding common terminal 36, and the A terminals 38 are disconnected from the common terminals 36. In this case, when the coil 21 is energized, it should be so energized that, referring to Fig. 3 for the polarity of the magnets, a north pole is developed on the left end of the iron core 23 while a south pole is developed on the right end thereof. In this case, corresponding to the shown polarities of the permanent magnets 32, it will be clear that both ends 23a and 23b of the iron core 23 will attract the iron plates 31 above them in the figure and will repel the iron plates 31 below them in the figure, and hence the armature pieces 29 will both be impelled downwards in the figure, thus moving the connection member 30 smoothly and straight downwards by overcoming the spring action of the spring pieces 47 so as to disconnect the B terminals 39 from the common terminals 36 and simultaneously to connect the A terminals 38 to said common terminals 36. This occurs in a symmetric fashion with respect to the center of gravity of the electromagnetic relay, thus not generating any off center jerking force or torque which could loosen the connection of the relay or of the terminals thereof. And when the energization of the coil 21 is terminated the action of the spring pieces 47 restores the connecting member 30 and the armature pieces 29 mounted thereon to their original upwards displaced positions, because in this case the action of the spring pieces 47 is arranged to be stronger than the attraction of the upper iron plate members 31 for the ends of the iron core 23 caused by the permanent magnets 32 alone. This reverse switching action again occurs without developing any off center jerking forces on the electromagnetic relay.

On the other hand, if the relay is in fact to be a latching type relay, then the sheet springs 47 on both of the sides of the member 30 are made of roughly the same strength, so that when the coil 21 is not energized, if there were no permanent magnets 32, the connecting member 30 would be biased approximately to the center of its transverse travel, and no connection would be made between any of the terminals of the relay. Also, the sheet springs 47 are arranged to be relatively weaker than in the case described above, so that, since in fact the permanent magnets 32 are incorporated, when the coil 21 is not energized, the connecting member 30 is positioned in one position or the other, either upwards or downwards, according as to which way the coil 21 was last energized. If for example the connecting member 30 is currently positioned in the upwards direction as seen in Figs. 3 to 5, then each of the B terminals 39 of the electromagnetic relay is electrically connected to its corresponding common terminal 36, and the A terminals 38 are disconnected from the common terminals 36, as specified above. From this state, if the coil 21 is energized in the direction which makes the left end of the iron core 23 into a north pole and the right end of the iron core 23 into a south pole, then the connecting member 30 does not move. On the other hand, if from this state the coil 21 is energized in the opposite direction which makes the left end of the iron core 23 into a south pole and the right end of the iron core 23 into a north pole as suggested in Fig. 3, then in a similar fashion to that described above both ends 23a and 23b of the iron core 23 will attract the iron plates 31 above them in the figure and will repel the iron plates 31 below them in the figure, and hence again the connection member 30 will be moved smoothly and straight downwards by overcoming the spring action of the spring pieces 47 so as to disconnect the B terminals 39 from the common terminals 36 and simultaneously to connect the A terminals 38 to said common terminals 36. Again, this occurs in a symmetric fashion with respect to the center of gravity of the electromagnetic relay, thus not generating any off center jerking force or torque which could loosen the connection of the relay or of the terminals thereof, so this switching action again occurs without developing any off center jerking forces on the electromagnetic relay. On the other hand, in this case when the energization of the coil 21 is terminated the action of the spring pieces 47 is not sufficient to move the connecting member 30 and the armature pieces 29 mounted thereon to their original upwards displaced positions, because of the attraction of the upper iron plate members 31 for the ends of the iron core 23 caused by the permanent magnets 32 which is stronger than the action of the sheet springs 47, and so the connecting member 30 and the armature pieces 29 remain in their downward position and the contact situation remains as described. This will be the case until the coil 21 is energized in the direction which makes the left end of the iron core 23 into a north pole and the right end of the iron core 23 into a south pole, i.e. in the opposite direction to the previous one, when the connecting member 30 and the armature pieces 29 will be moved back to their original upwards position. Thus, in summary, the action of the relay is that of a flip-flop device.

As described above, because the construction of this relay according to the first preferred embodiment of the present invention is symmetrical about its center of gravity, no off center jerking forces are caused when it is switched. Thus no unbalanced torque is generated, and accordingly no problems arise with regard to the fixing of the relay to a printed circuit board, and the risk that the fixing of the relay should become loosened is prevented. Further, this construction is accomplished without substantially increasing the bulk or the length of the relay. Yet further, since no crimped connection occurs between the iron core 23 and the yoke member 24, no risk occurs of bad connection therebetween deteriorating the quality of the magnetic circuit, and thus the shown construction is much better than that of the described prior art from the point of view of performing simple and reliable construction at a cheap cost.

Now, another feature of the present invention will be discussed with particular reference to the second through the fifth preferred embodiments thereof. First, however, in Figs. 6 and 7 there is shown a prior art type relay, respectively in a side and in a bottom view. This relay is for switching a high frequency current, and it is intended to be mounted on a printed circuit board, not shown. In order to avoid the problem, which is becoming more and more pressing nowadays with the increasingly smaller size of high frequency relays, that the high frequency current tends to leak from one terminal to another because these terminals are being made closer to one another, this know relay 101 of Figs. 6 and 7 is made as follows. A casing 102 is mounted over a relay mechanism (not shown) fixed on a base 103, and out from the bottom of said base 103 project a plurality of contact terminals 104 for receiving switched signals, a plurality of coil terminals 105 for receiving a switching signal, and a plurality of ground terminals 106. The base 103 is coated both on its external and its internal surfaces with conductive plating such as Cu-Ni plating, except for the immediate surroundings of the contact terminals 104 and the coil terminals 105; and the internal plating and the external plating on said base 103 are electrically connected together, as are also the external plating and the ground terminals 106. Thus, when the relay 101 is mounted on a printed circuit board, not shown, each of the terminals 104, 105, and 106 is poked through a corresponding mounting hole on the printed circuit board, and a ground surface formed on the printed circuit board contacts the ground terminals 106 as well as contacting the plating formed on the outside surface (the lower surface in Fig. 6) of the base 103 of the relay 101.

When the grounding contact between the plated outer surface of the base 103 and the ground surface on the printed circuit board is present and good, as well as the grounding contact between the ground terminals 106 and said printed board ground surface, then the amount of leakage of a high frequency switched signal can be as good as -74dB at 900MHz, as shown by the exemplary line (A) in Fig. 8. However, problems tend to arise in such a prior art, because since the surface of the printed circuit board and the plated outer surface of the base 103 are in close contact with one another for providing electrical connection, it is very difficult to eliminate any flux that gets in between these two surfaces. Such remaining flux can corrode the terminals, causing bad connections, and further by such corrosion the contact area between the surface of the printed circuit board and the plated outer surface of the base 103 is diminished, thereby deteriorating the high frequency characteristics of the assembly. In such a case, if the electrical connection between the printed circuit board ground surface and the plated outer surface of the base 103 substantially fails, only leaving the electrical connection between the printed circuit board ground surface and the ground terminals 106, then the amount of leakage of a high frequency switched signal can deteriorate to be as bad as -61dB at 900MHz, as shown by the exemplary line (B) in Fig. 8.

Now, in Figs. 9 and 10, a second preferred embodiment of the relay of the present invention is shown, which is so constructed as to avoid the above detailed problems. In this case, again a casing 102 is mounted over a relay mechanism (not shown, but in fact this is a two pole high frequency signal switching unit) fixed on a base 103, and the fringe 111 of the case 102 extends to some distance below the bottom of the base 103, as seen by the cutaway portion of Fig. 9. In the bottom of said base 103 and projecting out therefrom there are fixed: six contact terminals 104 for receiving switched signals, said contact terminals 104 being arranged in two longitudinally extending rows of three each; four coil terminals 105 for receiving a switching signal, each of said coil terminals 105 being provided at one longitudinal end of one of said two rows of three contact terminals 104; twelve ground terminals 106, one of which is provided on each longitudinal side of each of the contact terminals 104; and six stop/shield projections 107, which are much shorter in the vertical direction (perpendicular to the printed circuit board) than the terminals 104, 105, and 106 but are much longer than said terminals in the longitudinal direction, and which are provided one on the inside side of each of the contact terminals 104, being integrally formed with the base 103. Again, the base 103 is coated both on its external and its internal surfaces with conductive plating such as Cu-Ni plating, except for the immediate surroundings of the contact terminals 104 and the coil terminals 105 (according to this, squares and rectangles where the conductive plating is absent are shown in Fig. 10 as surrounding said terminals 104 and 105 - this configuration is obtained by masking during the plating process); and the internal plating and the external plating on said base 103 are electrically connected together, as are also the external plating and the ground terminals 106 and also the stop/shield projections 107. The shield plating formed of Cu-Ni on the inside of the case 102 is ·shown as 108 in Fig. 9. The length of each of the stop/shield projections 107 is slightly longer than the amount by which the fringe 111 of the case 102 projects downwards past the lower surface of the base 103, so that, when the relay 101 is mounted on a printed circuit board 110 as shown in Fig. 10 and is pushed firmly thereagainst, with each of the terminals 104, 105, and 106 poked through a corresponding mounting hole on the printed circuit board, then when the ends of the stop/shield projections 107 come into contact with the printed circuit board 110 a certain gap still is left between the fringe 111 of the case 102 and said printed circuit board 110, as well as a larger gap being left between the bottom outer surface of the base 103 and said printed circuit board 110. The end surfaces of the stop/shield projections 107 are flat, so that in this condition they well and properly contact the ground surface formed on the printed circuit board 110 (as well as of course do the ground terminals 106). Also these end surfaces of the stop/shield projections 107 are substantially parallel to the bottom surface of the base 103, again so as to ensure that they properly contact the ground surface of the printed circuit board 110.

Because of this gap left between the bottom outer surface of the base 103 and said printed circuit board 110, according to the provision of the stop/shield projections 107, it is much easier to ensure that no flux becomes trapped therebetween, and accordingly the risk of such trapped flux deteriorating the high frequency shielding characteristics of the relay is effectively prevented. The reason for the configuration shown in Figs. 9 and 10, with the ground terminals 106 on either side of each of the contact terminals 104, and with the elongated stop/shield projections 107 extending, on the inside side of each of the contact terminals 104, almost between the two corresponding ground terminals 106, is in order to better shield said contact terminals 104. As a modification of the shown embodiment, it would be possible to make each of the projections 107 in the form of a trough, in other words with an arcuate cross section from the point of view of Fig. 10 concave in the direction of the corresponding contact terminal 104; but this has not been done in the shown second preferred embodiment, in view of the desirability of facilitating the work of sealing the relay. Also, it would be possible to make the shown construction by integrally forming the stop/shield projections 107 with the base 103 of the relay, and by performing the Cu-Ni plating thereof later.

In the case of this second preferred embodiment, since the grounding contact between the plated outer surface of the base 103 and the ground surface on the printed circuit board through the projections 107 is virtually guaranteed to be present and good, and supplements effectively the grounding contact between the ground terminals 106 and said printed board ground surface, therefore the amount of leakage of a high frequency switched signal can be as good as -97dB at 900 MHz, as shown by the exemplary line (C) in Fig. 8.

In Figs. 11 and 12, a third preferred embodiment of the relay of the present invention is shown, in a fashion similar to Figs. 9 and 10 with regard to the second preferred embodiment. As opposed to the second embodiment, in which the ground terminals 106 were integrally formed with the base 103, according to this embodiment, after forming the ground terminals 106 as reed frame type and then inserting them in the base 103, Cu-Ni plating was performed on the base 103. Thereby, the assembly work was made easier than it was in the second preferred embodiment.

In Figs. 13 and 14, a fourth preferred embodiment of the relay of the present invention is shown, in a fashion similar to Figs. 9 and 10 with regard to the second preferred embodiment; and Fig. 15 shows a cross sectioal view of the relay in a plane shown by the arrows A - A in Fig. 13. As opposed to the second and third preferred embodiment, in which the high frequency insulation for the mechanism of the relay was provided by the Cu-Ni layer 108 on the inside of the case 102, in this third preferred embodiment a shield box 112 is formed from metallic plate and is fitted inside the relay 101 with the grounding terminals 106 and the stop/shield projections 107, which are integrally formed with and attached to said shield box 112, projecting through holes in the base 103, as best seen in section in Fig. 15. Thus, the electrical connection of the stop/shield projections 107 and the ground terminals 106 and the shielding material for the relay is effectively performed by a simple construction, in which plating work and other difficulties during assembly are eliminated.

In Figs. 16 and 17, a fifth preferred embodiment of the relay of the present invention is shown, in a fashion similar to Figs. 9 and 10 with regard to the second preferred embodiment. As opposed to the second and third preferred embodiments, in which the electrical connections between the ground terminals 106 and the stop/shield projections 107 were only made via the Cu-Ni plating on the surface of the base 103, in this fifth preferred embodiment these ground terminals 106 are constituted as downwards bent projections from a connecting body 113 which is made of a metal press formed plate and is fixed on the bottom of the base 103 and is located by projections 114 provided on the bottom surface of said base 103. With this connecting body 113 integrally connecting together the ground terminals 106 and also positively being pressed against and contacting the Cu-Ni plating on the bottom of the base 103 which is contacted with the stop/shield projections 107, the electrical connection between the ground terminals 106 and the stop/shield projections 107 is much more positively assured, and accordingly electrical integrity is improved.

Now, in Figs. 18, 19, and 20, a sixth preferred embodiment of the relay of the present invention is shown. Referring to the exploded view of Fig. 18, this relay is substantially made up of a base assembly 201, an electromagnet assembly 210, an armature assembly 220, a pair of restoring springs 230 and 235, and an outer case 240.

The base assembly 201 comprises a base 202 integrally molded from synthetic resin and a terminal platform 208. The base 202 has a slot 203 formed therein, and the terminal platform 208 is fixedly secured in this slot 203 and has fixed terminals 209a, 209b, and 209c mounted in it. Upper contacts 209a′, 209b′, and 209c′ of the terminals 209a, 209b, and 209c lie in the slot 203, and this slot 203 there are provided ground contacts 206a through 206f on the walls of the slot 203 adjacent to each of the terminals 209a, 209b, and 209c on either side thereof (see Fig. 19). Out from the bottom of the base 202 there project four ground terminals 207, and these ground terminals 207 and the ground contacts 206a through 206f are electrically connected together by a thin electroconductive film of Cu-Ni deposited on the surface of the base 202. (Of course, this electroconductive film does not touch the fixed terminals 209a, 209b, 209c).

The electromagnet assembly 210 comprises a spool 212 through the middle of which there is fitted an iron core 211 and on which there is wound a coil 217. The spool 212 is connected to a yoke member 219, which, as in the first preferred embodiment of the present invention described earlier, has two upward projecting pole pieces 219a and 219b at each of its ends which are positioned on the two sides of the corresponding projecting end of the iron core 211. In detail, the connection between the spool 212 and the yoke member 219 is accomplished by platform members 213 being fitted on either end of the spool 212 and by the upward projecting pole piecees 219a being fitted through slots 213a in the platform members 213 while the inside surfaces of the pole pieces 219b are contacted to the outer surfaces of side portions 213b of the platform members 213. And coil terminals 218, 218, are fixedly mounted in the platform members 213 and project downwards therefrom through appropriate holes in the base 212, not particularly shown.

The armature assembly 220 comprises a body portion 221 which is integrally molded from synthetic resin, and at each end of this body portion 221 there are mounted in frame portions 222 two plate pieces 226a and 226b and a permanent magnet 227 bridging between them so as to define a C-shape, similar to the layout used in the first preferred embodiment described earlier, and with the orientations of the permanent magnets 227, 227 opposite to one another as in said first embodiment. Further, insulated contact carrying members 228, 228 are fitted into holes 223 formed in said body portion 221, and each of these contact carrying members 228 carries a pair of springy contact pieces 229a and 229b extending on both its sides. The armature assembly 220 is so disposed that, at each of its ends, the plate pieces 226a and 226b are inserted into the aforementioned gaps defined between the end of the iron core 211 and the pole pieces 219a and 219b, with some movement remaining therebetween. And the armature assembly 220 is held in this position by two sheet springs 230 and 235 in such a fashion as to be movable transversely to and fro, against a restoring force provided by these sheet springs, through a certain distance in the directions A and A′ (see Fig. 19).

The sheet spring 230 is fixed to the base 202 by its central portion 231 being fitted into a slot 205a formed in said base 202, and its end portions 232 are fitted into slots 224 formed in the body portions 221 of the armature assembly 220. On the other hand, the sheet spring 235 is fixed to the armature assembly 220 by hooked or notched shape portions 236 at its center portion (whose notch shape extends along the longitudinal direction of said sheet spring 235) being loosely fitted over corresponding projections 225 formed on the body portion 221 of said armature assembly 220, and its end portions 237, 237 are fitted into slots 205b formed in the base 202. The spring forces of the sheet springs 230 and 235 are given by the lines (P) and (Q) respectively in Fig. 22, which is a graph showing stroke of the armature assembly 220 against the force applied (by the electromotive action of the electromagnet assembly 210) thereto: the graph of the spring force of the spring 230 is a straight line, and the graph of the spring force of the spring 235 is a straight line bent in the middle thereof. The right hand base line alpha in Fig. 22 shows the situation when the armature assembly 220 is fully displaced in the A′ direction, while conversely the left hand base line beta shows the situation when it is fully displaced in the A direction.

Specifically, when the electromagnetic coil 217 is deenergized then, since in this particular embodiment the iron core 211 of the electromagnet assembly 210 is magnetized, an attractive force exists between the two end surfaces of the iron core 211 and the plate pieces 26b, 26b, while a repulsive force exists between said end surfaces of the iron core 211 and the plate pieces 26a, 26a, and hence the armature assembly 220 moves in the direction of the arrow A′ in Fig. 19, so that the two ends of the springy contact piece 229a contact the contacts 209b′ and 209c′, while the two ends of the springy contact piece 229b contact the ground contacts 206a and 206b and bend somewhat while doing so. On the other hand, when the electromagnetic coil 217 is energized, then an attractive force exists between the two end surfaces of the iron core 211 and the plate pieces 26a, 26a, while a repulsive force exists between said end surfaces of the iron core 211 and the plate pieces 26b, 26b and hence the armature assembly 220 moves in the direction of the arrow A in Fig. 19, so that the two ends of the springy contact piece 229b contact the contacts 209a′ and 209c′ while the two ends of the springy contact piece 229a contact the ground contacts 206d and 206f and bend somewhat while doing so.

In other words, in this preferred embodiment, the armature assembly 220 moves to and fro in the directions of the arrows A and A′ according to the energization or non energization of the coil 217, and switches the contacts 209a′ and 209c′, and 209b′ and 209c′. The overall load curve is defined by the curve (X) in Fig. 22, being made up by combining the curves (P) and (Q) representing the spring forces of the springs 230 and 235 and the curves (R) and (S) representing the spring forces of the springy contact pieces 229a and 229b. This resultant load curve (X) is so shaped as to conveniently fall, as does the ideal load curve (C) illustrated in Fig. 21, between the actuation property curve (A) and the restoring property curve (B).

In detail, the adjustment of the load curve (X) of this relay can be made by adjusting the characteristics of the sheet springs 230 and 235, which is based on their bending angles. As seen from Fig. 22, the graph (P) of the spring force of the sheet springs 230 is effectively a straight line, and adjustment of the strength of this spring has the effect of moving the load curve (X) up and down. On the other hand, the graph (Q) of the spring force of the sheet spring 235 is effectively a straight line bent at the middle of the stroke of the armature assembly 220, and adjustment of the strength of this spring has the effect determining the inclination angle of the load curve (X). And hence by adjusting the characteristics of these springs the characteristics of the relay can be set to be very suitable.

Since the sheet spring 235 is only loosely coupled to the armature assembly 220 by its central hooked portions 236 being loosely fitted over the projections 225 on the body portion 221, even when the forces of the spring portions on the two sides of said spring 235 differ somewhat, the spring 35 can shift according to this unbalance by the hooked or notched portions 236 shifting sideways on the projections 225, and thus even when the sheet spring 235 is irregular or asymmetric the parallel orientation of the armature assembly 220 to the coil 217 and the core 211 is maintained.

Finally, in Figs. 23 through 27, a seventh preferred embodiment of the relay of the present invention is shown. Because this seventh embodiment is very similar to the sixth embodiment, just described, only the portions thereof which differ from said sixth embodiment and which are important for understanding the particular principles exemplified by this seventh embodiment will be described. In Figs. 23 through 27 parts which correspond to parts of the sixth embodiment shown in Figs. 18 through 20 are denoted by the same reference numerals increased by a hundred. The relay is substantially made up of a base assembly 301, an electromagnet assembly 310, an armature assembly 320, a pair of restoring springs 330 and 335, and an outer case 340. The particular part of this seventh relay embodiment which differs from the sixth embodiment is the base assembly 301, which will now be described.

This base assembly 301 comprises a base 302 integrally molded from synthetic resin and a terminal platform 308. The base 302 has a slot 303 formed therein, and the terminal platform 308 is fixedly secured in this slot 303 and has fixed terminals 309a, 309b, and 309c mounted in it. Upper contacts 309a′, 309b′, and 309c′ of the terminals 309a, 309b, and 309c lie in the slot 303, and in this slot 303 there are provided ground contacts 302a′ through 302f′ on the walls of the slot 303 adjacent to each of the terminals 309a, 309b, and 309c on either side thereof (see Fig. 26). And a grounding base board 305 is press formed out of copper plate, and has six integrally formed ground terminals 306a through 306f extending in the one direction therefrom (the direction out from the body of the relay) and five also integrally formed mounting lugs 305a through 305e extending in the other direction therefrom (into the body of the relay). The mounting lugs 305a through 305e are formed with notches 307a through 307e for positive engagement. On the lower surface of the base 302 there is deposited a thin electroconductive film of Cu-Ni or the like - of course, this electroconductive film does not touch the fixed terminals 309a, 309b, and 309c - and the grounding base board 305 is fixed to the lower side of the base 302 by being pressed against with the mounting lugs 305a through 3053 slipping into and engaging positively (thanks to the notches 307a through 307e) with guide grooves 303a′ through 303e′ formed in the base 302. Thus the grounding base board 305 is in very good overall contact with the conducting coating film formed thereon for very good grounding. And the slot 303 in the base 302 is made up of slotlets 303e and 303f which communicate between larger sockets 303a, 303b, and 303c; these shapes are for receiving fatter portions of the terminals platform 308 which accomodate the terminals 309a through 309c and for receiving the thinner portions 308e and 308f of the terminal platform 308 joining these fatter portions.

The assembly process of this base assembly 301 will now be described. After the grounding base board 305 has been fitted to the base 302 as explained above by the mounting lugs 305a through 305e engaging with the guide grooves 303a′ through 303e′, then the terminal platform 308 is pushed into the slot 303, with the fatter terminal receiving portions thereof fitted into the socket shapes 303a, 303b, and 303c and with the thinner portions 308e and 308f fitted into the slotlets 303e and 303f, and with the side faces 308a through 308d defined on the terminal platform 308 (see Fig. 24) pushing strongly against the side inner surfaces of the socket shapes 303a, 303b, and 303c. Thereby a very good sealing structure is obtained. At this time, since the grounding base board 305 is very strongly and positively contacted against the conducting coating film formed on the outer surface of the base 302, a very good ground is obtained, and there is no problem as there was with the prior art of poor and restricted contact between the ground terminals and the conducting coating for shielding.

Also in this seventh and last preferred embodiment since the ground terminals 306a through 306d and the mounting lugs 305a through 305d are arranged on the opposite sides of the terminals 309a, 309b, and 309c, leakage of high frequency signals is well guarded against. And because the grounding base plate 305 is pressed hard against the base 302 and positively holds the terminals platform 308 in the slot 303 thereof, a very good sealing effect is obtained.

Although the present invention has been shown and described with reference to the preferred embodiments thereof, and in terms of the illustrative drawings, it should not be considered as limited thereby. Various possible modifications, omissions, and alterations could be conceived of by one skilled in the art to the form and the content of any particular embodiment, without departing from the scope of the present invention.

## Claims

1. An electromagnetic relay, comprising
a core (23) made of magnetic material,
an electromagnetic coil (21) wound around said core so that the two ends of said core project therefrom and consistute first and second core end poles (23a, 23b),
a yoke member (24) having first and second ends and extending generally parallel to said core, said yoke member (24) being formed at said first end thereof with two first pole pieces (27a1, 27b1) which lie on each side of said first end pole (23a) of the core (23) with a certain gap being defined between said first end pole of the core and each of said first pole pieces (27a1, 27a2) of the yoke member,
an armature block comprising a first armature piece (29) including a permanent magnet plate (32) and two plates (31) of magnetic material fixed to said permanent magnet plate so as to form a generally C-shaped body, with one of said magnetic material plates (31) being magnetized to be a north pole and the other one being magnetized to be a south pole, the two plates (31) of magnetic material being inserted one on each side of said first end pole of said core into the corresponding gap, and an actuating member (30) fixed to said first armature piece,
a base (28) for mounting said yoke (24) thereon, characterized
by fixed and movable contacts (37, 40, 41, 42) disposed on both sides of said base, and
by a pair of chambers (35), disposed on both sides of said base (28), for electromagnetically shielding said fixed and movable contacts (37, 40, 41, 42), wherein said armature block makes a translation transversely to the longitudinal axis of said core (23) and yoke member (24), thereby establishing and breaking electrical connection between said fixed and movable contacts (37, 40, 41, 42).

FIG. 1

FIG. 2

FIG. 3

FIG. 4

FIG. 5

# F I G. 6

101

102

103

105  104  106  104  106  104  105

# F I G. 7

105  104  106  104  106  104  105

102

103

# F I G. 8

Frequency (MHz)

250    400    600    800    1000    1200

(B)

(A)

(C)

Leakage Between Different Poles (dB)

50

60

70

80

90

EP 0 334 393 A2

F I G. 9

F I G.10

F I G.11

F I G.12

*F I G. 13*

*F I G. 14*

*F I G. 15*

F I G. 16

F I G. 17

F I G. 18

EP 0 334 393 A2

FIG. 19

FIG. 20

F I G. 21

# F I G. 22

F I G. 23

# FIG. 24

FIG.25

FIG.26

FIG.27